(19)

Europäisches
Patentamt
European
Patent Office
Office européen
des brevets

(11) **EP 2 684 924 A1**

(12) **EUROPEAN PATENT APPLICATION**
published in accordance with Art. 153(4) EPC

(43) Date of publication:
**15.01.2014 Bulletin 2014/03**

(21) Application number: **12754253.8**

(22) Date of filing: **02.03.2012**

(51) Int Cl.:
*C09J 7/02* (2006.01)       *C08L 27/06* (2006.01)
*C08L 67/02* (2006.01)       *C09J 133/00* (2006.01)
*C09J 201/00* (2006.01)

(86) International application number:
**PCT/JP2012/055410**

(87) International publication number:
**WO 2012/121155 (13.09.2012 Gazette 2012/37)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.03.2011   JP 2011049753**

(71) Applicants:
• **Nitto Denko Corporation
  Ibaraki-shi, Osaka 567-8680 (JP)**
• **Nitto Europe N.V.
  3600 Genk (BE)**

(72) Inventors:
• **YUTOU, Takumi
  Ibaraki-shi
  Osaka 567-8680 (JP)**
• **ASAI, Fumiteru
  Ibaraki-shi
  Osaka 567-8680 (JP)**

• **SHINTANI, Toshio
  Ibaraki-shi
  Osaka 567-8680 (JP)**
• **SUZUKI, Toshitaka
  Ibaraki-shi
  Osaka 567-8680 (JP)**
• **HANAOKA, Minoru
  Ibaraki-shi
  Osaka 567-8680 (JP)**
• **THYS, Edwin
  B-3600 Genk (BE)**
• **FORIER, Bart
  B-3600 Genk (BE)**

(74) Representative: **Hoefer & Partner
  Pilgersheimer Straße 20
  81543 München (DE)**

(54) **ADHESIVE TAPE OR SHEET**

(57)    A polyvinyl chloride-based adhesive tape or sheet has a base material layer formed to include 10 to 40 parts by weight of plasticizing agent(s) in relation to 100 parts by weight of a polyvinyl chloride-based resin and an adhesive layer on one surface of the base material layer, the plasticizing agent includes at least one type of plasticizing agent having an SP value of at least 9.0.

EP 2 684 924 A1

**Description**

Technical Field

The present invention relates to an adhesive tape or sheet, and more particularly, relates to a polyvinyl chloride-based adhesive tape or sheet used a polyvinyl chloride-based resin as a base material.

Background Art

Generally, polyvinyl chloride (PVC) based films that include a plasticizing agent such as dioctyl phthalate (DOP), dibutyl phthalate (DBP) exhibit superior mechanical characteristics, that is to say, are configured with both the rigidity exhibited by PVC and the flexibility exhibited by a plasticizing agent, and are used not only as a base material layer of a protective member of a processed surface for various types of steel plates such as stainless steel, aluminum, or the like, but also are widely used as a base material that exhibits superior vibration absorption characteristics, expanding characteristics, self-repair characteristics after expanding, or the like that are required during dicing, and that is used in the base material layer of an adhesive tape for dicing processes.
A phthalate-based plasticizing agent such as DOP or the like exhibits superior compatibility with PVC-based films and adhesives, particularly with acrylic adhesives, and when used as a plasticizing agent for an adhesive tape, exhibits low bleeding onto the surface and stabilizes the adhesive performance. Furthermore, stability is achieved since changes to the mechanical characteristics of the tape are minimized even under temperature variation from low temperatures (-10 degrees C) to high temperatures (50 degrees C).
However, the increasing tendency in recent years to review the use of phthalate-based plasticizing agents such as DOP, DBP, or the like that are PVC plasticizing agents in light of increasing environmental concerns has been heightened in response to the European REACH Regulations.
Use in PVC-based films of non-phthalate-based plasticizing agents such DINCH (diisononyl cyclohexane dicarboxylate) and TOTM (tri (2-ethylhexyl) trimellitate), or high molecular weight-type polyester plasticizing agents have been proposed as substitutes for the above compounds (see, Patent Documents 1 to 3, or the like).
However, there is the problem that the non-phthalate-based plasticizing agents exhibit poor compatibility with acrylic adhesives, the stability when configured as an adhesive tape is poor, and surface deposition of the plasticizing agent is conspicuous. As a result, the adhesive strength in relation to an adhesive tape (roll configuration or sheet-shaped) is unstable, and practical difficulties are associated with applications as a substitute for DOP.
The high molecular weight-type polyester plasticizing agents, or the like exhibit restricted movement in the PVC-based adhesive tape, and therefore have the advantage that deposition onto the surface is limited. However, since the plasticizing effect differs in comparison to current phthalate-based plasticizing agents such as DOP, or the like, there are difficulties associated with maintaining the same mechanical characteristics.
Patent Document 1: JPH02-84455A
Patent Document 2: JPH04-57874A
Patent Document 3: JP2001-302866A

Disclosure of the Invention

Problem to be Solved

The present invention has the object of providing a polyvinyl chloride-based adhesive tape or sheet that substantially avoids use of a phthalate-based plasticizing agent such as DOP, DBP, or the like, and which exhibits the same or better performance when compared to an adhesive tape or sheet that uses a phthalate-based plasticizing agent.

Means for Solving the Problem

The present application includes the inventions as follows.

[1] a polyvinyl chloride-based adhesive tape or sheet having;

a base material layer formed to include 10 to 40 parts by weight of plasticizing agent(s) in relation to 100 parts by weight of a polyvinyl chloride-based resin and
an adhesive layer on one surface of the base material layer,

the plasticizing agent includes at least one type of plasticizing agent having an SP value of at least 9.0.

[2] The polyvinyl chloride-based adhesive tape or sheet of [1],
wherein the plasticizing agent having an SP value of at least 9.0 is an low molecular weight polyester plasticizing agent having a number average molecular weight Mn of 800 to 1500 and a weight average molecular weight Mw of 800 to 2000.
[3] The polyvinyl chloride-based adhesive tape or sheet of [2],
wherein the low molecular weight polyester plasticizing agent is an adipate-based polyester plasticizing agent.
[4] The polyvinyl chloride-based adhesive tape or sheet of [2],
wherein the low molecular weight polyester plasticizing agent is a plasticizing agent having isononyl terminal or n-octyl terminal.
[5] The polyvinyl chloride-based adhesive tape or sheet of [1] or [2],
wherein the plasticizing agent is substantially free from 2-diethylhaxyl phthalate and dibutyl phthalate.
[6] The polyvinyl chloride-based adhesive tape or sheet of [1] or [2],
wherein the adhesive layer includes acrylic polymer as a base polymer and set an SP value of 8.9 to 9.5.
[7] The polyvinyl chloride-based adhesive tape or sheet of any one of [1] to [6], further comprising a separator on a surface of the adhesive layer.

Effect of the Invention

According to the present invention, it is possible to provide a polyvinyl chloride-based adhesive tape or sheet that substantially avoids use of a phthalate-based plasticizing agent such as DOP, DBP, or the like, and which exhibits the same or better performance when compared to an adhesive tape or sheet that uses a phthalate-based plasticizing agent.

Description of Embodiments

The polyvinyl chloride-based adhesive tape or sheet according to the present invention (hereinafter, may be simply referred to as "adhesive tape") includes a base material layer and an adhesive layer on one surface of the base material layer. The base material layer is formed to include a polyvinyl chloride-based resin and a plasticizing agent(s) in which the SP value of at least one type of plasticizing agent is at least 9.0.

The present inventors discovered that a plasticizing agent bleeds onto the surface of a base material layer when a polyvinyl chloride-based resin base material layer that uses a conventional plasticizing agent is configured as an adhesive tape resulting in unstable adhesive characteristics, and conducted diligent research in relation to this phenomenon.

As a result, it was discovered that there is a difference in the bleed phenomenon of the plasticizing agent onto the base material layer surface depending on the type of adhesive in the adhesive layer, and that the bleed phenomenon of the plasticizing agent onto the base material layer surface exhibits a correlation to the magnitude of the SP value of the plasticizing agent. In particular, it was discovered that the bleed phenomenon of the plasticizing agent onto the base material layer surface is conspicuous, and that there is a correlation relationship between the SP value of the plasticizing agent in the PVC and the surface bleed when an acrylic adhesive is coated onto a PVC base material layer and configured as an adhesive tape, in comparison to use of a rubber-based adhesive.

In the prior-art technique, the polyester plasticizing agent that is included in the polyvinyl chloride-based base material layer is limited to a configuration that uses a rubber-based adhesive as an adhesive layer.

On the other hand, it was newly discovered that the bleed of the plasticizing agent onto the base material layer surface could be conspicuously inhibited by adjusting the SP value of the plasticizing agent in the PVC in an adhesive tape including a polyvinyl chloride-based base material layer that uses an acrylic adhesive in the adhesive layer.

Conventionally, a technique has been adopted in which the molecular weight of the polyester plasticizing agent or the like is increased in order to inhibit the bleed of the plasticizing agent onto the base material layer surface.

On the other hand, it was newly discovered that the bleed of the plasticizing agent onto the base material layer surface could be inhibited by adjusting the SP value regardless of the molecular weight.

Furthermore, it was discovered that adjustment of the SP value of the plasticizing agent eliminates restriction to the type or molecular weight, and in the absence of use of a phthalate-based plasticizing agent, enables maintenance of the mechanical characteristics of the PVC base material layer, that is not possible by use of the conventional technique, to an equivalent degree or to a higher degree, as a phthalate-based plasticizing agent (for example, the same behavior that results from use of a phthalate-based plasticizing agent is exhibited in relation to physical characteristics such as viscosity, elasticity, or the like across a broad temperature range). This feature constitutes a considerable advantage as a future substitute technique for phthalate-based plasticizing agents.

(Base Material Layer)

The base material layer is formed by formulating a polyvinyl chloride-based resin and at least one type of plasticizing agent.

The polyvinyl chloride-based resin denotes various polymers that employ vinyl chloride as the principal monomer (the main component of the monomer components, that is to say, the monomers that occupy at least 50 mass%). In other words, a homopolymer constituted by vinyl chloride monomers, and a copolymer that is formed from a vinyl chloride monomer and various comonomers are included.

The comonomer includes vinylidene chloride; olefins such as ethylene, propylene (preferably olefins having $C_{2-4}$); carboxyl group-containing monomers or acid anhydride thereof such as acrylic acid, methacrylic acid (hereinafter, acryl and methacryl may be generally referred to as "(meth)acryl"), maleic acid, fumaric acid or the like (maleic anhydride, or the like); (meth)acrylate, e.g., esters of (meta) acrylic acid and a $C_{1-10}$ alcohol alkyl or a cycloalkyl alcohol; vinyl ester monomers such as vinyl acetate, vinyl propionate, or the like; styrene-based monomers such as styrene, substituted styrene ($\alpha$-methyl styrene, or the like), vinyl toluene, or the like; acrylonitrile, or the like.

Average degree of polymerization may be, for example, about 800 to 1500, preferably about 1000 to 1300.

The copolymer of vinyl chloride monomers includes vinyl chloride copolymers such as an urethane-vinyl chloride copolymer, an ethylene-vinyl chloride copolym6er, a vinyl acetate-vinyl chloride copolymer, an ethylene-vinyl acetate copolymer, or the like.

The vinyl chloride monomer homopolymer and the copolymers of vinyl chloride monomers may be constituted from only one type, or may be a mixture of two or more types. Furthermore, a mixture with other resin or elastomer may be used. In this configuration, it is preferred that the polymerization ratio of vinyl chloride in relation to polyvinyl chloride and the copolymer is at least 70 mass%, and more preferably at least 90 mass%.

(Plasticizing Agent for Base Material Layer)

There is no particular limitation in relation to the plasticizing agents used in the base material layer as long as it is usually used as a plasticizing agent for the polyvinyl chloride resin. The plasticizing agents include, for example, adipetes (J-Plus Co., Ltd. D-620, D-620N, dioctyl adipate, diisononyl adipate, etc.), trimellitates (Dainippon Ink Co., Ltd. W-700 trioctyl trimellitate, etc.), phosphates (tricresyl phosphate, etc.), citrate (tributyl acetyl citrate, etc.), sebacic esters, azelaic esters, maleic esters, phthalic esters, benzoic esters, polyether-esters, epoxy-esters (epoxidized soybean oil, epoxidized linseed oil, etc.), polyesters (low molecular weight polyester consisting of a carboxylic acid and a glycol), and the like. These may be used either alone or mixture of two or more type.

It is suitable that at least one type of plasticizing agent used in the base material layer exhibits a solubility parameter (an SP value: calculated using Small's formula (1)) of at least 9.0. Here, an SP value of the plasticizing agent means estimate value calculated by the formula (1) which is the Small's formula.

$$\sigma p\ [(J/cm^3)^{1/2}] = \Sigma F/V \qquad (1)$$

wherein, $\sigma p$ represents solubility parameter, F represents constant related to intermolecular interaction, which is Small's constant as shown in Table 1, and depends on the type of substitution group, V represents molecular volume.

[Table 1]

| Type | F [$J^{1/2}$mol] | Type | F [$J^{1/2}$/mol] |
|---|---|---|---|
| $-CH_3$ | 438 | H | 164 ~ 205 |
| $-CH_2-$ | 272 | OH | - |
| $CH_2=$ | 389 | O (ether) | 143 |
| CH- | 57 | CHO | 685 ~ 767 |
| $-CH(CH_3)_2$ | 933 | CO (ketone) | 563 |
| $-CH=$ | 227 | COOH | 798 ~ 839 |
| -C- | 190 | COO (ester) | 634 |
| C= | 39 | $CH_3COO$ | 1072 |
| CHC- | 583 | CN | 839 |
| -C=C- | 454 | Cl (mean) | 532 |
| $-CH=CH_2-$ | 616 | Cl (single) | 552 |

(continued)

| Type | F [$J^{1/2}$mol] | Type | F [$J^{1/2}$/mol] |
|---|---|---|---|
| Phenyl | 1504 | Cl (as in $CCl_2$) | 532 |
| Cyclohexyl | - | Cl (as in $CCl_3$) | 511 |
| Phenylene (o, m, p) | 1346 | Br (single) | 696 |
| Naphenyl | 2345 | I (single) | 870 |
| Five-membered ring | 215 ~ 235 | $CF_2$ (n-hydrocarbons) | 307 |
| Six-membered ring | 194 ~ 215 | $CF_3$ (n-hydrocarbons) | 552 |
| Conjugation | 41 ~ 61 | S (sulfides) | 460 |
| $NO_3$ (nitrates) | 900 | SH (thiols) | 644 |
| $NO_2$ (aliphalic nitro) | 900 | $PO_4$ (organic phosphates) | 1023 |

The plasticizing agent that has an SP value of at least 9.0 specifically includes various types of adipate plasticizing agents or phthalate plasticizing agents such as those manufactured by ADEKA Corporation (Adeka Sizer PN-7160, Adeka Sizer PN-9302, or the like), those manufactured by J-PLUS Co., Ltd (D-620, D620N, or the like), and those manufactured by DIC Corporation (W-230-H, W-225-EL, W-1040-S), or the like.

Of the above compounds, the plasticizing agent having an SP value of at least 9.0 is preferably an ester/polyester plasticizing agent.

The ester/polyester plasticizing agent for example is preferably an adipate plasticizing agent (phthalate plasticizing agent) in which a polyol is reacted with adipic acid (or phthalic acid). A polyol as referred to herein includes a glycol such as ethylene glycol, propylene glycol, diethylene glycol, or the like.

The terminals of the adipate plasticizing agent or phthalate plasticizing agent include various types of alcohol. There is no particular limitation in relation to the alcohol, and for example, the alcohol generally includes isononyl alcohol, n-octyl alcohol, 2-ethylhexyl alcohol, or the like. The composition of the terminal is not limited in relation to characteristics, and use of isononyl alcohol, n-octyl alcohol, or the like is more practical in light of the stability of impurities formed during the reaction step.

The plasticizing agent having an SP value of at least 9.0 preferably has a number average molecular weight Mn of 800 to 1500, and more preferably 800 to 1200, and 1000 to 1200. As used herein, Mn means a value that is measured by use of GPC.

The plasticizing agent having an SP value of at least 9.0 preferably has a weight average molecular weight Mw of 800 to 2000, and more preferably 800 to 1500, and 1000 to 1500. As used herein, Mw means a value that is measured by use of GPC.

Of the above, the plasticizing agent having an SP value of at least 9.0 is preferably an ester/polyester plasticizing agent having Mn of 800 to 1500 and Mw of 800 to 2000.

The plasticizing agent is suitably formulated by mixing 10 to 40 parts by weight in relation to 100 parts by weight of the polyvinyl chloride-based resin, and from the point of view of maintaining mechanical characteristics, a formulation of 10 to 30 parts by weight, or formulation of 20 to 30 parts by weight is preferred. The plasticizing agent having an SP value of at least 9.0 may be more than 0 parts by weight in relation to total plasticizing agent, for example, suitably 70 parts by weight or more, preferably 90 parts by weight or more, and more preferably 100 parts by weight.

The base material layer may include an additive that is known in this field, such as a stabilizer, a filler, a lubricant, a coloring agent, an ultraviolet absorption agent, an anti-oxidation agent, an anti-ageing agent, a weathering stabilizer, or the like as required (for example, when used outdoors).

There is no particular limitation in relation to the stabilizer, and the stabilizer include a barium-zinc based, a tin based, a calcium-zinc based, or a cadmium-barium based composite stabilizing agent, or the like.

The filler includes an inorganic filler such as calcium carbonate, silica, mica or the like, or a metal filler such as iron, lead or the like.

The colorant includes a pigment such as white, black, blue, green, red, etc., a dye or the like. Weather resistance pigments such as carbon black, oxidized titanium, zinc oxide, or the like may be added as for the weather resistance formula.

The base material layer may be a single-layer film, or may be a laminated film (multilayer film) including different materials or compositions.

There is no particular limitation in relation to the thickness of the base material layer, and the thickness may about 30 to about 1000 $\mu$m, preferably about 50 to about 200 $\mu$m.

The front and rear surfaces, and in particular, the front surface of the base material layer, that is to say, the surface on the side provided with the adhesive layer, may be processed using a customary surface processing method, such as an oxidizing process or the like using a chemical or physical method such as corona processing, chromic acid processing, ozone exposure, exposure to a flame, exposure to high-voltage electric shock, ion irradiation processing, or the like in order to improve the adhesion with the adhesive agent.

(Adhesive Layer)

There is no particular limitation in relation to the adhesive layer as long as the adhesive layer has a configuration that is typically used in adhesive tapes or the like, and formation is possible by use of a variety of adhesives.

The base polymer that is used in the adhesive for example may be suitably selected from base polymers that configure known adhesives such as rubber-based adhesives [natural rubbers; modified natural rubbers which is graft-polymerized appropriately MMA (methyl methacrylate) with natural rubbers; synthetic rubbers such as styrene-butadiene rubber (SBR), butyl rubber, isoprene rubber (IR), butyl rubber (IIR), etc.]; block polymers such as styrene-ethylene-butylene-styrene (SEBS), etc.; acrylic adhesives, polyamide adhesives, silicone adhesives, polyester adhesives, urethane adhesives, or the like. Of the above compounds, an acrylic polymer that is a base polymer for the configuration of an acrylic adhesive is preferably used due to superior performance in relation to various characteristics such as heat resistance, weathering performance, or the like, and due to realization of desired performance as a result of the selection of the type of monomer component that configures the acrylic polymer. Furthermore, bleeding of the plasticizing agent in the base material layer onto the base material layer surface can be more effectively inhibited by use of an acrylic polymer that has a large SP value.

The acrylic copolymer that is the base polymer of the acrylic adhesive is configured by a (meth)acrylic alkyl ester as a main monomer component.

Examples of the (meth)acrylic alkyl ester include a $C_{1-20}$ alkyl (meth)acrylate (preferably a $C_{1-12}$ alkyl (meth) acrylate, and more preferably a $C_{1-8}$ alkyl (meth)acrylate) such as methyl (meth)acrylate, ethyl (meth)acrylate, propyl (meth)acrylate, isopropyl (meth)acrylate, butyl (meth)acrylate, isobutyl (meth)acrylate, s-butyl (meth)acrylate, t-butyl (meth)acrylate, pentyl (meth)acrylate, hexyl (meth)acrylate, heptyl (meth)acrylate, octyl (meth)acrylate, 2-ethylhexyl (meth)acrylate, isooctyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, octadecyl (meth)acrylate, nonadecyl (meth)acrylate, eicosyl (meth)acrylate or the like. These alkyl (meth)acrylates may be used singly or in a combination of two or more.

The acrylic copolymer may include a unit that is corresponding to the other monomer component which is copolymerizable with the alkyl (meth)acrylate if desired for the purpose of modifying cohesion force, heat resistance, cross-linking performance or the like.

Examples of such monomer component include, for example,

carboxyl group-containing monomers such as acrylic acid, methacrylic acid, carboxyethyl acrylate, carboxypentyl acrylate, itaconic acid, maleic acid, fumaric acid and crotonic acid;

hydroxyl group-containing monomers such as hydroxy (meth)acrylate, hydroxybutyl (meth)acrylate, hydroxyhexyl (meth) acrylate, hydroxyoctyl (meth)acrylate, hydroxydecyl (meth)acrylate, hydroxyrauryl (meth)acrylate, (4-hydroxymethyl cyclohexyl)methyl(meth)acrylate;

sulfonate group-containing monomers such as styrenesulfonic acid, allylsulfonic acid, 2-(meth) acrylamide-2-methyl propanesulfonic acid, (meth)acrylamide propanesulfonic acid, sulfopropyl (meth)acrylate, (meth)acryloyl oxynaphthalenesulfonic acid;

phosphate group-containing monomers such as 2-hydroxyethyl acryloylphosphate;

(N-substituted) amide-based monomers such as (meth)acrylamide, N,N-dimethyl (meth)acrylamide, N-butyl (meth)acrylamide, N-methylol (meth)acrylamide, N-methylolpropane (meth)acrylamide;

aminoalkyl (meth)acrylate-based monomers such as aminoethyl (meth)acrylate, N,N-dimethylaminoethyl(meth)acrylate, t-butylaminoethyl (meth)acrylate;

alkoxyalkyl (meth)acrylate-base monomers;

maleimide-based monomers such as N-cyclohexyl maleimide, N-isopropyl maleimide, N-lauryl maleimide, N-phenylmaleimide;

itaconimide-based monomers such as N-methyl itaconimide, N-ethyl itaconimide, N-butyl itaconimide, N-octhyl itaconimide, N-2-ethylhexyl itaconimide, N-cyclohexyl itaconimide, N-lauryl itaconimide,

succinimide-based monomers such as N-(meth)acryloyl oxymethylene succinimide, N-(meth)acryloyl-6-oxyhexamethylene succinimide, N-(meth)acryloyl-8-oxyoctamethylene succinimide,

vinyl-based monomers such as vinyl acetate, vinyl propionate, N-vinylpyrrolidone, methyl vinylpyrrolidone, vinyl pyridine, vinyl piperidone, vinyl pyrimidine, vinyl piperazine, vinyl pyrazine, vinyl pyrrole, vinyl imidazole, vinyl oxazole, vinyl morpholine, N-vinyl carboxylic acid amides, styrene, $\alpha$-methyl styrene, N-vinyl caprolactam;

cyanoacrylate-based monomers such as acrylonitrile, metacryloni tril;

epoxy group-containing acrylic monomers such as glycidyl (meth)acrylate;

glycol-based acrylate monomers such as polypropylene glycol (meta)acrylate, methoxyethyl glycol (meta)acrylate, methoxypolypropylene glycol (meta)acrylate;

acrylate monomers which contains a heterocycle, a halogen atom, a silicon atom or the like such as tetrahydrofurfuryl, fluorine (meta) acrylate, silicone (meta) acrylate;

multifunctional monomers such as hexanediol di(meta) acrylate, (poly)ethylene glycol di(meta) acrylate, polypropylene glycol di(meta) acrylate, neopentyl glycol di(meta) acrylate, pentaerythritol di(meta) acrylate, trimethylol propane tri(meta) acrylate, pentaerythritol tri(meta) acrylate, dipentaerythritol hexa(meta) acrylate, epoxy acrylate, polyester acrylate, urethane acrylate, divinylbenzene, butyl di(meta) acrylate, hexyl di(meta) acrylate;

olefine monomers such as isoprene, dibutadiene, isobtylene;

vinyl ether-based monomers such as vinyl ether, or the like. These monomer components may be used singly or in a combination of two or more.

The acrylic copolymer can be produced by polymerizing the above the alkyl (meth)acrylate and an other monomer if desired according to the appropriate known method such as emulsion polymerization, solution polymerization.

There are no particular restrictions on the molecular weight or the like of the acrylic copolymer, for example, that having the weight average molecular weight of 150,000 to 2,000,000 (for example, 200,000 to 2,000,000, 200,000 to 1,500,000, or 1,000,000 to 2,000,000) can be used, 150,000 to 1,000,000 is preferable, and 300,000 to 1,000,000 is more preferable. The weight average molecular weight can be measured as a corresponding value of polystyrene by gel permeation chromatograph (GPC), for example.

The adhesive can be an energy ray curable adhesive by adding an energy ray polymerizable compound, by incorporating an energy ray polymerizable double bond into the base polymer, or the like. The adhesive layer using the energy curable adhesive exhibits sufficient adhesive forth before energy ray-irradiation and markedly decreases adhesive forth after energy ray-irradiation, therefore, it is possible to easily peel without providing stress to adherend. Examples of the energy ray include ultraviolet ray, electron ray, or the like.

A compound having two or more of energy ray polymerizable carbon-carbon double bond in its molecule can be used as the energy ray polymerizable compound. Examples of such compound include multifunctional acrylic compound, for example.

Examples of the multifunctional acrylic compound include, for example,

(meth) acrylates of a liner aliphatic polyol such as 1,4-butylene di(meth)acrylate, 1,5-pentandiol di(meth)acrylate,1,6-hexanediol di(meth)acrylate, 1,9-nonanediol di(meth)acrylate, polyethylene glycol di(meth)acrylate, polypropylene glycol di(meth)acrylate;

(meth) acrylates of an aliphatic polyol having alicyclic group such as cyclohexane dimethanol di(meth)acrylate, tricyclodecane dimethanol di(meth)acrylate;

(meth) acrylates of a branched chain aliphatic polyol such as trimethylolpropane tri(meth)acrylate, pentaerythritol tri (meth)acrylate, pentaerythritol tetra(meth)acrylate;

condensation products such as ditrimethylolpropane tetraacrylate, dipentaerythritol hexaacrylate, or the like.

These may be used singly or in a combination of two or more.

A multifunctional urethane acrylic oligomer such as an urethane acrylic oligomer can be used as the energy polymerizable compound, for example.

The urethane acrylic oligomer can be obtained by reacting an urethane oligomer which is obtained by reacting a diisocyanate compound with an polyol compound, and an alkyl (meth)acrylate having a hydroxy group, for example.

Examples of the diisocyanate compound include, for example, tolylene diisocyanate, diphenylmethan diisosianate, hexamethylene diisocyanate, phenylene diisosianate, dicyclohexyl methan diisosianate, xylene diisosianate, tetramethylxylene diisosianate, naphthalene diisosianate, isophorone diisosianate, or the like.

Examples of the polyol compound include

polyalcohols such as ethylene glycol, 1,4-buthanediol, 1,6-hexanediol, diethylene glycol, trimethylolpropane, dipropylene glycol, polyethylene glycol, polypropylene glycol, pentaerythritol, dipentaerythritol, glycerin or the like;

polyester-based polyol compounds which is obtained by condensation reacting the polyalcohol and an aliphatic dicarboxylic acid such as adipic acid, sebacic acid, azelaic acid, maleic acid or an aromatic dicarboxylic acid such as terephthalic acid, isophthalic acid;

polyether-based polyol compounds such as polyethylene ether glycol, polypropylene ether glycol, polytetramethylene ether glycol, polyhexamethylene ether glycol;

lactone-based polyol compounds such as polycaprolactone glycol, polypropiolactone glycol, polyvalerolactone glycol;

polycarbonate-based polyol compounds which is obtained by the de-alcoholizing reaction of polyalcohol such as ethylene glycol, propylene glycol, butanediol, pentanediol, octanediol, nonanediol or the like and diethylene carbonate, dipropylene carbonate or the like.

Examples of the hydroxyl group-containing alkyl (meth)acrylate compound include 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydodecyl (meth)acrylate, 12-hydroxyrauryl (meth)acrylate, (4-hydroxymethyl cyclohexyl) methyl(meth)acrylate, or the like.

The energy ray polymerizable compound is used in a ratio of 5 to 200 parts by weight to 100 parts by weight of the base polymer, is preferably used in 10 to 100 parts by weight, and is more preferably used in 10 to 45 parts by weight.

A method of incorporating the energy ray polymerizable double bond into the base polymer is a method in which copolymerizable monomers having a reactive functional group such as carboxyl group, hydroxyl group, amino group and the like are copolymerized when an acrylic polymer which is the base polymer, is prepared, for example. This leads the base polymer to incorporate the functional groups which are basic points of the reaction, and allows to bond the multifunctional monomer or oligomer having the energy ray polymerizable double bond to the base polymer via the functional groups which are basic points of the reaction, thereby obtaining a base polymer having the energy ray polymerizable carbon-carbon double bond in the side chain.

The energy ray curable adhesive may include a photopolymerization initiator as required. The photopolymerization initiator causes radicals through excitation and activation by irradiation of the energy ray, and promotes an efficient polymerizing and curing reaction of the adhesive layer.

Examples of the photopolymerization initiator include, for example,
benzoine alkyl ether-based initiators such as benzoine methyl ether, benzoine ethyl ether, benzoine isopropyl ether, benzoine isobutyl ether;
benzophenone-based initiators such as benzophenone, benzoylbenzoate, 3,3'-dimethyl-4-methoxybenzophenone, polyvinyl benzophenone;
aromatic ketone-based initiators such as $\alpha$-hydroxy cyclohexyl phenyl ketone, 4-(2-hydroxy ethoxy) phenyl (2-hydroxy-2-propyl) ketone, $\alpha$-hydroxy-$\alpha,\alpha$'-dimethyl acetophenone, methoxyacetophenone, 2,2-dimethoxy-2-phenyl acetophenone, 2,2-diethoxyacetophenone;
aromatic ketal-based initiators such as the benzyl dimethyl ketal;
thioxanthone-based initiators such as thioxanthone, 2-chlorothioxanthone, 2-methylthioxanthone, 2-ethylthioxanthone, 2-isopropylthioxanthone, 2-dodecylthioxanthone, 2,4-dichlorothioxanthone, 2,4-dimethylthioxanthone, 2,4-diethylthioxanthone, 2,4-diisopropylthioxanthone;
benzyl-based initiators such as benzyl;
benzoin-based initiators such as benzoin;
$\alpha$-ketol-based compounds such as 2-methyl-2-hydroxypropylphenon;
aromatic sulfonyl chloride-based compounds such as 2- naphthalene sulfonyl chloride;
light-active oxime compounds such as 1-phenon-1,1-propanedione-2-(o-ethoxycarbonyl) oxime;
camphor chinone; ketone halide; acyl phosphinoxide; acyl phosphonate and the like. These may be used singly or in a combination of two or more.

The adhesive may be a hydrophilic adhesive which is provided hydrophilic properties by neutralizing part or all of acidic group contained in the base polymer, which is used a polymer having an acidic group such as carboxy group as the base polymer and is added a neutralizer thereto. The hydrophilic adhesive generally causes the adherend few adhesive residues, and it is possible to remove easily with washing with pure water, even though the adhesive causes adhesive residues.

The polymer having an acidic group can be obtained by copolymerizing the monomers having the acidic group such as carboxyl-containing monomer described above when the base polymer is prepared.

Examples of the neutralizer include, for example, primary amines such as monoethylamine, monoethanolamine; secondary amines such as diethylamine, diethanolamine; tertiary amines such as triethylamine, triethanolamine, N,N,N'-trimethyl ethylenediamine, N-methyl diethanolamine, N,N-diethyl hydroxylamine; organic amino compounds indicating the alkalinity.

The adhesive may include an cross-linker as required.

As the cross-linker, epoxy-based cross-linker, isocyanate-based cross-linker, melamine-based system cross-linker, peroxide-based cross-linker, metal alkoxide-based cross-linker, metal chelate-based cross-linker, metal salt-based cross-linker, carbodiimide-based cross-linker, oxazoline-based cross-linker, aziridine-based cross-linker, amine-based cross-linker can be used. The epoxy based cross-linker and isocyanate-based cross-linker can be preferably used. These may be used singly or in a combination of two or more. Of the above, isocyanate-based cross-linker, glycidylamine-based cross-linker, melamine-based system cross-linker, or the like is preferred.

Examples of the isocyanate-based cross-linker include, for example, lower aliphatic polyisocyanates such as 1,2-ethylene diisocyanate, 1,4-butylene diisocyanate, 1,6-hexamethylene diisocyanate; aliphatic polyisocyanates such as cyclopentylene diisocyanate, cyclohexylene diisocyanate, isophorone diisocyanate, hydrogenation tolylene diisocyanate, hydrogenation xylene diisocyanate; aromatic polyisocyanates such as tolylene diisocyanates (e.g., 2,4-tolylene diisocyanate, 2,6-tolylene diisocyanate (colonate-L (Nippon Polyurethane industry co. ltd.), DESMODUR-L75 (BAYER.A.G), or the like), 4,4'-diphenyl methane diisocyanate (milionate MR-300 (Nippon Polyurethane industry co. ltd.), or the like), xylylene diisocyanate, or the like.

Examples of the glycidylamine-based cross linking agent include, for example, N,N,N',N'-tetraglycidyl-m-xylenediamine, diglycidylaniline, 1,3-bis(N,N-glycidylaminomethyl) cyclohexane (TETRAD-C (Nippon Gas Chemical company, inc.)), 1,6-hexandioldiglycidylether, neopentyl glycol diglycidylether, ethylene glycol diglycidylether, propylene glycol diglycidylether, polyethylene glycol diglycidylether, polypropylene glycol diglycidylether, sorbitol polyglycidyl ether, glycerol polyglycidyl ether, pentaerythritol polyglycidyl ether, polyglycerol polyglycidyl ether, sorbitane polyglycidyl ether, trimethylolpropane polyglycidyl ether, diglycidyl adipate, diglycidyl o-phthalate, triglycidyl-tris(2-hydroxyethyl)isocyanurate, resorcin diglycidyl ether, bisphenol-S-diglycidyl ether, epoxy resin having 2 or more epoxy group in its molecule.

Examples of the melamine-based cross linking agent include, for example, butanol modified melamine formaldehyde resin (SUPER BECKAMINE J-820-60N (Nippon Polyurethane industry co. ltd.)), and Luwipal 012 (BASF).

The added amount of the cross linking agent is preferably about 0.05 to about 20 parts by weight relative to 100 parts by weight of the base polymer that configures the adhesive. In particular, when acrylic-based polymers is used as the base polymer, it is suitably that the isocyanate-based cross-linker, glycidylamine-based cross-linker, melamine-based system cross-linker, or the like is used alone or mixture of two or more.

There is no particular limitation on the thickness of the adhesive layer, it is preferably 1 to $50\mu$m, more preferably 1 to 30 $\mu$m.

The adhesive layer preferably includes a plasticizing agent. The plasticizing agent includes the same compounds as those described above, and generally includes use alone of a plasticizing agent that exhibits an SP value of at least 9.0, or use together with an epoxy-based plasticizing agent.

In this configuration, the added amount of the plasticizing agent may be suitably determined using a proportion of 0 to 100 parts by weight, preferably 10 to 80 parts by weight, and more preferably 10 to 60 parts by weight relative to 100 parts by weight of the base polymer that configures the adhesive.

The adhesive layer may also include an additive such as tackifier, a stabilizer, a flexibilizer, a process oil, a filler, a lubricant, a colorant, a UV absorbing agent, an antioxidant, a dye, a weather resistance stabilizer or the like as required. These additives may be the same as those described above.

(Separator)

The separator (may be referred as "release liner") may be a commonly used liner in this technical field, and may be used without any particular limitation thereon. For example, a base such as a film formed from paper; rubber; various foils such as aluminum foil, copper foil, stainless foil, iron foil, duralumin fiol, tin foil, titanium foil, gold foil; film made of various resins such as polyethylene, polypropylene, polyethylene terephthalate (PET), polyvinyl chloride, polyester, polyamide; foams such polyurethane foam, vinyl foam, polyethylene foam, stylene foam; nonwoven fabric; woven fabric; felt, and a laminate of these materials with a polymer material may be used as a base material.

There is no particular limitation on the thickness of the base material, it suitably falls within a range of 5 $\mu$m to 5 mm, and preferably 30$\mu$m to 100 $\mu$m.

The surface on the side that comes into contact with the adhesive layer or both surfaces in this type of base material may be die release treated by a known method in this technical field, which includes laminate coating of a die release agent such as a silicone-based resin, a long-chain alkyl-based resin, fluorine-based resin, low molecular weight polyethylene, polypropylene, a rubber-based polymer and a phosphate-based surface active agent, and the like.

The separator/release liner may include one or a plurality of slits (in a so-called back cut configuration) that have a linear, waved, serrated or saw toothed shape to improve the adhesive operation performance when adhereing the adhesive tape to an adherend.

The separator/release liner enables a configuration of an adhesive tape that includes a separator/release liner by attachment to the adhesive layer after formation of the adhesive tape. This type of adhesive tape may be stored, conveyed or the like in a sheet configuration attached to the release liner, or may be wound into a rolled configuration with reference to or without reference to the release liner described above for storage and conveying.

(Method of Manufacture of Adhesive Tape)

The base material layer and the adhesive layer of the adhesive tape according to the present invention may be formed separately by using a method that is known in this technical field. For this purpose, for example, a method such as a melt extrusion molding method (an inflation method, a T die method, or the like), a melt casting method, a calendar method or the like may be used.

In particular, the adhesive layer may be formed by applying the adhesive described above onto a base material using a suitable method such as knife coating, roller coating, gravure coating, die coating, reverse coating, or the like in addition to the above method. Further, for example, the adhesive layer may be formed on a suitable casting process sheet such as a film surface processed using a mold release process, and then the adhesive layer may be transferred onto the thermoplastic film. Furthermore, the adhesive layer may be formed separately or with the base material layer by using the extrusion.

When the thermoplastic resin film and the pressure sensitive adhesive layer are formed separately, both layers may be laminated using a method that is known in this technical field. Furthermore, the thermoplastic resin film and the pressure sensitive adhesive layer may be formed as a multilayer structure by a co-extrusion method, a laminating method (extrusion lamination method, a lamination method using an adhesive or the like), and a heat seal method (external heating method, internal heating method, or the like).

(Adhesive Tape)

The adhesive tape according to the present invention includes a base material layer which is substantially free of the plasticizing agent, which is formed from 2-diethylhexyl phthalate and dibutyl phthalate. Furthermore, it is preferred that the plasticizing agents are also free from the adhesive layer. As used herein, the terms free or substantially free means that the compounds are not used as additives in the base material layer, and preferably the adhesive layer, and more preferably, means a concentration on the basis of quantitative analysis of no more than 5000 ppm on a weight basis.

A configuration which is free of these specific plasticizing agents ensures compliance with environmental considerations and meets the trend of the European REACH Regulations.

The adhesive tape may be used for various applications. Examples of the application may include an adhesive tape for surface-protecting during processing (various processing such as wringing, bending, punching, etc.), storing, transporting, or the like of steel plate such as stainless or aluminum, optical devices or film, resin, glass or the like; for fixing of wafers during semiconductor processing; for back-grinding of semiconductors; for dicing of semiconductors; for dicing of semiconductor packages, glass, ceramics, or the like; or for protecting wafer surfaces or circuit surfaces during such processes.

Examples of a polyvinyl chloride adhesive tape or sheet according to the present invention will be described in detail below.

Example 1

A 70-$\mu$m soft PVC film was prepared to contain 27 parts by weight of an adipate-based low molecular weight polyester plasticizing agent (Adeka Sizer PN-7160 manufactured by ADEKA Corporation) relative to 100 parts by weight of PVC resin with a degree of polymerization of P = 1050.

A toluene solution of an adhesive including 100 parts by weight of an acrylic copolymer (BA/AN/AA = 85/15/2.5: Mw = 800,000), 10 parts by weight of a melamine-based cross linking agent (butanol-modified melamine formaldehyde resin : SUPER BECKAMINE J-820-60N manufactured by Nippon Polyurethane), and 60 parts by weight of an adipate-based low molecular weight polyester plasticizer (manufactured by ADEKA CORPORATION Adeka Sizer PN-7160, molecular weight: Mw= 1600).

The adhesive solution is coated onto one side of the base material layer that is formed from PVC, dried for 90 seconds at 130 degrees C to form a 10-$\mu$m adhesive layer on the PVC surface.

Example 2

A 70-$\mu$m soft PVC film was prepared to contain 27 parts by weight of an adipate-based low molecular weight polyester plasticizing agent (Adeka Sizer PN-9302 manufactured by ADEKA Corporation) relative to 100 parts by weight of PVC resin with a degree of polymerization of P = 1050.

A toluene solution of an adhesive including 100 parts by weight of an acrylic copolymer (BA/AN/AA = 85/15/2.5: Mw = 800,000), 10 parts by weight of a melamine-based cross linking agent (butanol-modified melamine formaldehyde resin: SUPER BECKAMINE J-820-60N manufactured by Nippon Polyurethane), and 60 parts by weight of an adipate-based low molecular weight polyester plasticizer (manufactured by ADEKA CORPORATION Adeka Sizer PN-9302, molecular weight: Mw= 1600).

The adhesive solution is coated onto one side of the base material layer that is formed from PVC, dried for 90 seconds at 130 degrees C to form a 10-$\mu$m adhesive layer on the PVC surface.

Example 3

A 70-$\mu$m soft PVC film was prepared to contain 27 parts by weight of an adipate-based low molecular weight polyester plasticizing agent (D-620N manufactured by J-plus Corporation) relative to 100 parts by weight of PVC resin with a degree of polymerization of P = 1050.

A toluene solution of an adhesive including 100 parts by weight of an acrylic copolymer (BA/AN/AA = 85/15/2.5: Mw = 800,000), 10 parts by weight of a melamine-based cross linking agent (butanol-modified melamine formaldehyde resin : SUPER BECKAMINE J-820-60N manufactured by Nippon Polyurethane), and 60 parts by weight of an adipate-based low molecular weight polyester plasticizer (D-620N manufactured by J-plus Corporation, molecular weight: Mw= 1600).

The adhesive solution is coated onto one side of the base material layer that is formed from PVC, dried for 90 seconds at 130 degrees C to form a 10-μm adhesive layer on the PVC surface.

Example 4

A 70-μm soft PVC film was prepared to contain 27 parts by weight of an adipate-based low molecular weight polyester plasticizing agent (Adeka Sizer PN-9401 manufactured by ADEKA Corporation) relative to 100 parts by weight of PVC resin with a degree of polymerization of P = 1050.

A toluene solution of an adhesive including 100 parts by weight of an acrylic copolymer (BA/AN/AA = 85/15/2.5: Mw = 800,000), 10 parts by weight of a melamine-based cross linking agent (butanol-modified melamine formaldehyde resin : SUPER BECKAMINE J-820-60N manufactured by Nippon Polyurethane), and 60 parts by weight of an adipate-based low molecular weight polyester plasticizer (Adeka Sizer PN-9302 manufactured by ADEKA CORPORATION, molecular weight: Mw= 1600).

The adhesive solution is coated onto one side of the base material layer that is formed from PVC, dried for 90 seconds at 130 degrees C to form a 10-μm adhesive layer on the PVC surface. After forming the adhesive layer, it is stuck to a 38-μm PET film treated with Si to obtain an adhesive tape.

Comparative Example 1

A 70-μm soft PVC film was prepared to contain 27 parts by weight of DOP relative to 100 parts by weight of PVC resin with a degree of polymerization of P = 1050.

A toluene solution of an adhesive including 100 parts by weight of an acrylic copolymer (BA/AN/AA = 85/15/2.5: Mw = 800,000), 10 parts by weight of a melamine-based cross linking agent (butanol-modified melamine formaldehyde resin: SUPER BECKAMINE J-820-60N manufactured by Nippon Polyurethane), and 60 parts by weight of DOP.

The adhesive solution is coated onto one side of the base material layer that is formed from PVC, dried for 90 seconds at 130 degrees C to form a 10-μm adhesive layer on the PVC surface.

Comparative Example 2

A 70-μm soft PVC film was prepared to contain 27 parts by weight of TOTM relative to 100 parts by weight of PVC resin with a degree of polymerization of P = 1050.

A toluene solution of an adhesive including 100 parts by weight of an acrylic copolymer (BA/AN/AA = 85/15/2.5: Mw = 800,000), 10 parts by weight of a melamine-based cross linking agent (butanol-modified melamine formaldehyde resin: SUPER BECKAMINE J-820-60N manufactured by Nippon Polyurethane), and 60 parts by weight of TOTM.

The adhesive solution is coated onto one side of the base material layer that is formed from PVC, dried for 90 seconds at 130 degrees C to form a 10-μm adhesive layer on the PVC surface.

Comparative Example 3

A 70-μm soft PVC film was prepared to contain 27 parts by weight of DINCH (hexanol DINCH manufactured by BASF) relative to 100 parts by weight of PVC resin with a degree of polymerization of P = 1050.

A toluene solution of an adhesive including 100 parts by weight of an acrylic copolymer (BA/AN/AA = 85/15/2.5: Mw = 800,000), 10 parts by weight of a melamine-based cross linking agent (butanol-modified melamine formaldehyde resin: SUPER BECKAMINE J-820-60N manufactured by Nippon Polyurethane), and 60 parts by weight of DINCH (hexanol DINCH manufactured by BASF).

The adhesive solution is coated onto one side of the base material layer that is formed from PVC, dried for 90 seconds at 130 degrees C to form a 10-μm adhesive layer on the PVC surface.

Comparative Example 4

A 70-μm soft PVC film was prepared to contain 27 parts by weight of an adipate-based low molecular weight polyester plasticizing agent (D-620N manufactured by J-plus Corporation) relative to 100 parts by weight of PVC resin with a degree of polymerization of P = 1050.

A toluene solution of an adhesive including 100 parts by weight of an acrylic copolymer (BA/AN/AA = 85/15/2.5: Mw = 800,000), 10 parts by weight of a melamine-based cross linking agent (butanol-modified melamine formaldehyde resin: SUPER BECKAMINE J-820-60N manufactured by Nippon Polyurethane), and 60 parts by weight of an adipate-based low molecular weight polyester plasticizer (D-623N manufactured by J-plus Corporation, molecular weight: Mw= 3600).

The adhesive solution is coated onto one side of the base material layer that is formed from PVC, dried for 90 seconds at 130 degrees C to form a 10-μm adhesive layer on the PVC surface.

The storage stability and mechanical performance were evaluated as described below in relation to an adhesive tape by way of examples and comparative examples. The results are shown in Table 2 to Table 5.

(Adhesive Strength)

Adhesive tape is attached using a linear pressure of 78 N/cm and a velocity of 0.3 m/min to a SUS430BA plate and a SUS304BA plate that are immersed in toluene and cleaned using ultrasonic cleaning. The adhesive tape is cut into a 20 mm width, and the initial adhesive strength is measured at a velocity of 0.3 m/min and 30m/min. The initial adhesive strength was measured 30 minutes after attachment.

(Self Rear-Surface Adhesive Strength)

A release processing agent was coating using Meyer bar # 16 to the rear surface of the base material layer of each adhesive tape in the examples and comparative examples. The adhesive tape that was prepared by attaching an adhesive layer to the rear surface is cut into 20 mm widths to thereby measure the resistance during development at a velocity of 0.3 and 30 m/min.

(Breaking Strength)

The respective examples of adhesive tape in the examples and comparative examples are cut into 10 mm widths, pulled at a velocity of 0.3 m/min for 50 mm between a chuck in an atmosphere of -5 degrees C to thereby measure the force when the film broke.

Breaking Extension)

The respective examples of adhesive tape in the examples and comparative examples are cut into 10 mm widths, pulled at a velocity of 0.3 m/min for 50 mm between a chuck in an atmosphere of -5 degrees C to thereby measure the coefficient of extension with reference to the initial value when the film broke.

[Table 2]

|  |  | Ex. 1 | Ex. 2 | Ex. 3 | Ex. 4 |
|---|---|---|---|---|---|
| Degree of polymerization |  | 1050 | 1050 | 1050 | 1050 |
| Film plasticizing agent type |  | PN-7160 | PN-9302 | D620N | PN-9401 |
| Adhesive plasticizing agent type |  | PN-7160 | PN-9302 | D620N | PN-9401 |
| Amount of plasticizing agent |  | 29 | 29 | 29 | 29 |
| Molecular weight of plasticizing agent |  | 1600 | 1600 | 1600 | 1600 |
| Terminal composition |  | isononyl | n-octyl | isononyl | isononyl |
| SP value |  | 9.0 | 9.4 | 9.0 | 9.0 |
| Adhesibility to SUS430 BA plate [N/20mm] | 0.3 m/min | 1.02 | 1.37 | 1.18 | 1.17 |
|  | 3 0 m/min | 5.60 | 5.60 | 7.00 | 6.00 |
| Adhesibility to SUS304 BA plate [N/20mm] | 0.3 m/min | 2.05 | 3.06 | 2.31 | 2.31 |
|  | 3 0 m/min | 8.00 | 10.00 | 10.80 | 10.00 |
| Adhesibility to self-back surface [N/20mm] | 0.3 m/min | 0.10 | 0.15 | 0.13 | 0.14 |
|  | 30 m/min | 0.48 | 0.60 | 0.44 | 0.48 |

[Table 3]

|  |  | Comparative Examples | | | |
|---|---|---|---|---|---|
|  |  | 1 | 2 | 3 | 4 |
| Degree of polymerization |  | 1050 | 1050 | 1050 | 1050 |
| Film plasticizing agent type |  | DOP | TOTM | DINCH | D623 |
| Adhesive plasticizing agent type |  | DOP | TOTM | DINCH | D623 |
| Amount of plasticizing agent |  | 29 | 29 | 29 | 29 |
| Molecular weight of plasticizing agent |  | 391 | 547 | 422 | 3600 |
| Terminal composition |  | isononyl | n-octyl | isononyl | n-octyl |
| SP value |  | 9.5 | 8.7 | 8.8 | 9.3 |
| Adhesibility to SUS430 BA plate [N/20mm] | 0.3 m/min | 1.16 | 1.19 | 0.81 | 2.00 |
|  | 30 m/min | 6.00 | 1.60 | 2.20 | 1.00 |
| Adhesibility to SUS304 BA plate [N/20mm] | 0.3 m/min | 2.78 | 3.45 | 2.65 | 3.32 |
|  | 3 0 m/min | 12.00 | 9.00 | 7.60 | 3.50 |
| Adhesibility to self-back surface [N/20mm] | 0.3 m/min | 0.07 | 0.10 | 0.06 | 0.55 |
|  | 30 m/min | 0.30 | 0.10 | 0.05 | 0.10 |

[Table 4]

|  |  | Ex. 1 | Ex. 2 | Ex. 3 | Ex. 4 |
|---|---|---|---|---|---|
| Degree of polymerization |  | 1050 | 1050 | 1050 | 1050 |
| Film plasticizing agent type |  | PN-7160 | PN-9302 | D620N | PN-9401 |
| Adhesive plasticizing agent type |  | PN-7160 | PN-9302 | D620N | PN-9401 |
| Amount of plasticizing agent |  | 29 | 29 | 29 | 29 |
| Molecular weight of plasticizing agent |  | 1600 | 1600 | 1600 | 1600 |
| Terminal composition |  | isononyl | n-octyl | isononyl | isononyl |
| SP value |  | 9.0 | 9.4 | 9.0 | 9.0 |
| Breaking Strength [N] | MD | 38.5 | 40.7 | 41.0 | 43.3 |
|  | TD | 35.8 | 36.1 | 30.3 | 37.3 |
| Breaking Extension [%] | MD | 253 | 246 | 275 | 311 |
|  | TD | 267 | 237 | 130 | 299 |

[Table 5]

|  | Comparative Examples | | | |
|---|---|---|---|---|
|  | 1 | 2 | 3 | 4 |
| Degree of polymerization | 1050 | 1050 | 1050 | 1050 |
| Film plasticizing agent type | DOP | TOTM | DINCH | D623 |
| Adhesive plasticizing agent type | DOP | TOTM | DINCH | D623 |
| Amount of plasticizing agent | 29 | 29 | 29 | 29 |
| Molecular weight of plasticizing agent | 391 | 547 | 422 | 3600 |

(continued)

|  |  | Comparative Examples | | | |
|---|---|---|---|---|---|
|  |  | 1 | 2 | 3 | 4 |
| Terminal composition |  | isononyl | n-octyl | isononyl | n-octyl |
| SP value |  | 9.5 | 8.7 | 8.8 | 9.3 |
| Breaking Strength [N] | MD | 35.3 | 40.3 | 39.4 | 45.2 |
|  | TD | 33.0 | 39.0 | 36.6 | 32.3 |
| Breaking Extension [%] | MD | 184 | 247 | 255 | 11 |
|  | TD | 209 | 272 | 256 | 14 |

Industrial Applicability

The polyvinyl chloride-based adhesive tape or sheet according to the present invention is useful for surface protecting during processing (various processing such as wringing, bending, punching, etc.), storing, transporting, or the like of steel plate such as stainless or aluminum, and for fixing of wafers during semiconductor processing or dicing of semiconductors.

**Claims**

1. A polyvinyl chloride-based adhesive tape or sheet comprising;
   a base material layer formed to include 10 to 40 parts by weight of plasticizing agent(s) in relation to 100 parts by weight of a polyvinyl chloride-based resin and
   an adhesive layer on one surface of the base material layer,
   the plasticizing agent includes at least one type of plasticizing agent having an SP value of at least 9.0.

2. The polyvinyl chloride-based adhesive tape or sheet of Claim 1,
   wherein the plasticizing agent having an SP value of at least 9.0 is an low molecular weight polyester plasticizing agent having a number average molecular weight Mn of 800 to 1500 and a weight average molecular weight Mw of 800 to 2000.

3. The polyvinyl chloride-based adhesive tape or sheet of Claim 2,
   wherein the low molecular weight polyester plasticizing agent is an adipate-based polyester plasticizing agent.

4. The polyvinyl chloride-based adhesive tape or sheet of Claim 2,
   wherein the low molecular weight polyester plasticizing agent is a plasticizing agent having isononyl terminal or n-octyl terminal.

5. The polyvinyl chloride-based adhesive tape or sheet of Claim 1 or 2, wherein the plasticizing agent is substantially free from 2-diethylhaxyl phthalate and dibutyl phthalate.

6. The polyvinyl chloride-based adhesive tape or sheet of Claim 1 or 2, wherein the adhesive layer includes acrylic polymer as a base polymer and set an SP value of 8.9 to 9.5.

7. The polyvinyl chloride-based adhesive tape or sheet of Claim 1, further comprising a separator on a surface of the adhesive layer.

## INTERNATIONAL SEARCH REPORT

| | International application No. |
|---|---|
| | PCT/JP2012/055410 |

**A. CLASSIFICATION OF SUBJECT MATTER**
*C09J7/02*(2006.01)i, *C08L27/06*(2006.01)i, *C08L67/02*(2006.01)i, *C09J133/00*
(2006.01)i, *C09J201/00*(2006.01)i

According to International Patent Classification (IPC) or to both national classification and IPC

**B. FIELDS SEARCHED**

Minimum documentation searched (classification system followed by classification symbols)
C09J1/00-201/10, C08L27/06, C08L67/02

Documentation searched other than minimum documentation to the extent that such documents are included in the fields searched
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 2006-001951 A  (Lintec Corp.),<br>05 January 2006 (05.01.2006),<br>claims; examples<br>(Family: none) | 1,5-7<br>2-4 |
| X<br>A | JP 2010-189579 A  (Kuramoto Sangyo Co.),<br>02 September 2010 (02.09.2010),<br>comparative example 2<br>(Family: none) | 1,5-7<br>2-4 |
| X<br>A | JP 07-188619 A  (Sekisui Chemical Co., Ltd.),<br>25 July 1995 (25.07.1995),<br>claims; examples<br>(Family: none) | 1,5-7<br>2-4 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>11 April, 2012 (11.04.12) | Date of mailing of the international search report<br>22 May, 2012 (22.05.12) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2012/055410

C (Continuation). DOCUMENTS CONSIDERED TO BE RELEVANT

| Category* | Citation of document, with indication, where appropriate, of the relevant passages | Relevant to claim No. |
|---|---|---|
| X<br>A | JP 2011-037977 A (Bando Chemical Industries, Ltd.),<br>24 February 2011 (24.02.2011),<br>claims; examples<br>(Family: none) | 1,5-7<br>2-4 |
| A | JP 2004-283446 A (Duskin Co., Ltd.),<br>14 October 2004 (14.10.2004),<br>paragraphs [0014], [0015], [0055], [0069]<br>(Family: none) | 1-7 |
| Y | JP 2008-201911 A (Lintec Corp.),<br>04 September 2008 (04.09.2008),<br>claims; paragraphs [0019] to [0022]<br>(Family: none) | 1-7 |
| Y | JP 2004-175952 A (Riken Technos Corp.),<br>24 June 2004 (24.06.2004),<br>paragraph [0015]<br>(Family: none) | 1-7 |
| A | JP 11-061080 A (Nitto Denko Corp.),<br>05 March 1999 (05.03.1999),<br>paragraph [0019]<br>(Family: none) | 1-7 |

Form PCT/ISA/210 (continuation of second sheet) (July 2009)

**EP 2 684 924 A1**

## REFERENCES CITED IN THE DESCRIPTION

**Patent documents cited in the description**

- JP H0284455 A
- JP H0457874 A
- JP 2001302866 A